# EUROPÄISCHE PATENTSCHRIFT

(11) **EP 2 796 016 B1**
(45) Veröffentlichungstag und Bekanntmachung des Hinweises auf die Patenterteilung: **29.06.2016**
(21) Anmeldenummer: 12784229.2
(22) Anmeldetag: 30.10.2012
(51) Int. Cl.: H01L 23/31, H01L 23/367, H01L 23/495, H01L 23/498, H05K 1/14, H01L 23/00, H05K 1/18, H05K 3/28

(54) **GETRIEBESTEUERMODUL**
TRANSMISSION CONTROL MODULE
MODULE DE COMMANDE DE BOÎTE DE VITESSES

(30) Priorität: 19.12.2011 DE 102011088969
(43) Veröffentlichungstag der Anmeldung: 29.10.2014
(73) Patentinhaber: Robert Bosch GmbH, 70442 Stuttgart (DE)
(72) Erfinder: MEIER, Thomas, 71739 Oberriexingen (DE); MUELLER-VOGT, Ingo, 71706 Unterriexingen (DE)
(86) Internationale Anmeldenummer: PCT/EP2012/071426
(87) Internationale Veröffentlichungsnummer: WO 2013/091962

(56) Entgegenhaltungen:
- DE-A1-102004 011 808
- US-A1- 2005 230 818
- US-A1- 2006 281 230
- US-A1- 2009 126 967

## Beschreibung

### Stand der Technik

Die Erfindung betrifft ein Getriebesteuermodul mit den Merkmalen des Oberbegriffs des unabhängigen Anspruchs 1.

In der Getriebesteuerung sind Getriebesteuermodule bekannt, die außer einer elektronischen Getriebesteuereinrichtung einen beispielsweise für die elektrische Kontaktierung von Aktuatoren, Sensoren, Steckerteilen oder Stellmotoren vorgesehenen Grundträger aufweisen. Es ist bekannt, als Grundträger der elektrischen Verbindungstechnik eine Leiterplatte einzusetzen. Dabei werden die elektrischen Verbindungen vorzugsweise über innere Lagen der Leiterplatte geführt. Im Unterschied zu den klassischen Steuergeräten, welche eine Leiterplatte mit einer darauf angeordneten elektronischen Steuerschaltung innerhalb eines geschlossenen Metallgehäuses anordnen, benutzen diese Getriebesteuermodule eine konventionelle Leiterplatte als Grundträger des Moduls auch außerhalb des durch ein Gehäuse geschützten Bereichs. Derartige Module sind aufgrund der Verwendung der preiswerten und gut beherrschten Leiterplattentechnik besonders kostengünstig herstellbar. Ein solches Getriebesteuermodul ist beispielsweise aus der gattungsbildenden DE 10 2007 029 913 A1 bekannt. In der bekannten Schrift werden elektronische Bauelemente einer Getriebesteuerschaltung direkt auf die Leiterplatte bestückt und mit einem über den Bauelementen angeordneten Gehäuseteil abgedeckt. Da Getriebesteuermodule im Getriebe verbaut werden und dort dem Getriebefluid ausgesetzt sind, werden die nicht durch Gehäuseteile abgedeckten Bereiche der Leiterplatte dem aggressiven Getriebefluid ausgesetzt. Die Verwendung von konventionellen Leiterplatten als Träger der elektrischen Verbindungstechnik im Getriebefluid erfordert neue Aufbau- und Verbindungskonzepte.

Weiterhin sind beispielsweise aus der US 2010/0097775 A1 Steuergeräte bekannt, bei denen ein mit einer elektronischen Steuerschaltung versehener Schaltungsträger in ein Gehäuse aus Moldmasse komplett eingebettet wird. Für den Anschluss des Steuergerätes sind als flache Leiterstreifen ausgebildete elektrische Anschlüsse vorgesehen, die im Inneren der Moldmasse mit dem Schaltungsträger kontaktiert und mit ihren anderen Enden aus der Moldmasse herausgeführt sind. Derartige Steuergeräte können aber ohne einen damit verbundenen Grundträger für die Verbindungstechnik nicht zur Ansteuerung von Aktuatoren, Sensoren, Steckerteilen oder Stellmotoren einer Getriebesteuerung eingesetzt werden. Die Anordnung und Kontaktierung des Steuergerätes mit dem Grundträger ist problematisch, da besondere Maßnahmen notwendig sind, um die elektrischen Kontaktstellen zwischen Steuergerät und Grundträger gegen das Getriebefluid und darin enthaltene metallische Späne zu schützen.

Aus der US 2006/281230 A1 ist eine Leiterplatte bekannt, die mittels eines Klebers auf eine Metallplatte aufgebracht ist. Auf der Leiterplatte sind beidseitig Bauelemente aufgebracht. Einige dieser Bauelemente sind mir ihrer von der Leiterplatte abweisenden Seite in einer Aussparung der Metallplatte über einen thermischen Film auf die Metallplatte aufgebracht. Die Bauelemente kontaktieren die Leiterplatte mittels kugelförmiger Lötkontakte. Die Leiterplatte ist mit einer Abdeckmasse beschichtet, welche durch eine Öffnung der Leiterplatte in die Aussparung eingefüllt ist und die dort angeordneten Bauelemente umgibt.

Aus der US2009/126967 A1 ist eine Steuereinrichtung für eine Getriebe bekannt, bei der ein Hochtemperatursubstrat auf einer ersten Seite mit einer Moldmasse bedeckt ist und mit der gegenüberliegenden zweiten Seite über eine Karbonschicht auf der Außenseite eines Getriebes angeordnet ist.

Aus der US 2005/230818 A1 ist ein Steuermodul bekannt, das eine Leiterplatte aufweist. Auf wenigstens einer Lage der Leiterplatte sind Leiterbahnen zur elektrischen Verbindung eines Trägersubstrats einer elektronischen Steuerschaltung mit außerhalb des Trägersubstrats an der Leiterplatte angeordneten elektrischen/elektronischen Komponenten geführt, wobei die Leiterplatte wenigstens eine innere Leiterbahnlage aufweist, die als Zwischenlage zwischen zwei Isolierlagen der Leiterplatte angeordnet ist. Auf einer ersten Seite der Leiterplatte ist eine erste äußere Isolierlage mit einer Ausnehmung versehen ist, an deren Grund wenigstens Oberflächen von Leiterbahnabschnitten von Leiterbahnen der wenigstens einen inneren Leiterbahnlage angeordnet sind. Das Trägersubstrat ist von der ersten Seite der Leiterplatte in die Ausnehmung eingesetzt und mit den Oberflächen der Leiterbahnabschnitte der inneren Leiterbahnlage elektrisch kontaktiert. Die Ausnehmung ist mit einer das Trägersubstrat und die Leiterbahnabschnitte abdeckenden Moldmasse derart gefüllt ist, dass das Trägersubstrat und die Leiterbahnabschnitte durch die Moldmasse geschützt sind

### Offenbarung der Erfindung

### Vorteile der Erfindung

Das erfindungsgemäße Getriebesteuermodul ermöglicht eine einfache, besonders kompakte und gegenüber Getriebefluid dichte Integration einer Getriebesteuerschaltung in ein Getriebesteuermodul auf Basis einer Leiterplatte zur Herstellung der elektrischen Verbindungen zwischen der Getriebesteuerschaltung und den diversen anzusteuernden Komponenten des Moduls. Im Unterschied zur DE 10 2007 029 913 A1 wird die Getriebesteuerschaltung auf einem von der Leiterplatte separaten Trägersubstrat hergestellt. Als Trägersubstrat kann beispielsweise ein keramisches LTCC-Substrat (Low Temperature Cofired Ceramics) oder eine Mikroleiterplatte oder ein anderes geeignetes Trägersubstrat verwandt werden, das wenigstens auf einer Bestückungsseite mit elektrischen/elektronischen Bauelemente der Getriebesteuerschaltung bestückt ist. Das Trägersubstrat kann Leiterbahnen aufweisen, welche die Bauelemente des Trägersubstrats untereinander verbinden. Insbesondere können solche Leiterbahnen auch auf mehreren Lagen des Trägersubstrats vorgesehen sein, wobei auch innere Lagen des Trägersubstrats Leiterbahnen aufweisen können. Die Herstellung der Getriebesteuerschaltung auf einem Trägersubstrat, wie beispielsweise einem LTCC oder einer Mikroleiterplatte ist eine im Stand der Technik zuverlässig beherrschte Technik, so dass hier vorteilhaft auf bewährte Verfahren zurückgegriffen werden kann.

Die Erfindung geht von der Überlegung aus, dass die den Grundträger bildende Leiterplatte des Moduls Leiterbahnen zur Herstellung der elektrischen Verbindung zwischen Schaltung und Modulkomponenten wie beispielsweise Aktuatoren, Steckern und Sensoren auf zumindest einer geschützten inneren Leiterbahnlage aufweist. Wenigstens auf einer äußeren ersten Seite der Leiterplatte ist die dortige äußere Isolierlage mit einer Ausnehmung versehen, an deren Grund wenigstens Oberflächen von Leiterbahnabschnitten von Leiterbahnen der wenigstens einen inneren Leiterbahnlage angeordnet sind. Dies kann zum Beispiel in einfacher Weise dadurch geschehen, dass eine Ausnehmung mit beispielsweise rechteckförmigen Abmessungen in die äußere Isolierlage der Leiterplatte insbesondere gefräst ist, wobei bis auf die Leiterbahnen der inneren Leiterbahnlage durchgefräst wird. Die Ausnehmung kann auch in anderer geeigneter Weise eingebracht sein, wobei geeignete Material entfernende Bearbeitungsmethoden eingesetzt werden können oder die Ausnehmung bereits im Herstellungsprozess der Leiterplatte darin vorgesehen wird. Das Trägersubstrat mit der darauf angeordneten Schaltung ist von der ersten Seite der Leiterplatte in die Ausnehmung eingesetzt und mit den Oberflächen der freiliegenden Leiterbahnabschnitte der inneren Leiterbahnlage elektrisch kontaktiert, wozu verschiedene Kontaktierungstechniken eingesetzt werden können, wie noch erläutert wird. Durch die Anordnung des Trägersubstrats in der Ausnehmung wird die Gesamtdicke der Leiterplatte im Vergleich zur Anordnung des Trägersubstrats auf der Außenseite der Leiterplatte vorteilhaft reduziert.
Um die auf das Trägersubstrat aufgebrachte elektronische Getriebesteuerschaltung und die freiliegenden Leiterbahnabschnitte der inneren Leiterbahnlage gegen das aggressive Getriebefluid (ATF, automatic transmission fluid) zu schützen, ist die Ausnehmung mit einer zumindest das Trägersubstrat und die Leiterbahnabschnitte abdeckenden Moldmasse gefüllt Unter einer Moldmasse wird eine gegen Medien isolierende Umhüllungsmasse verstanden, welche in die Ausnehmung eingefüllt und ausgehärtet wird und dadurch eine gegenüber Getriebefluid dichte und gegen mechanische Einwirkungen schützende, feste Abdeckung bildet, die fest in die Leiterplatte integriert ist. Als Moldmasse kommt bevorzugt ein Duroplast zum Einsatz. Die Moldmasse kann insbesondere derart gewählt werden, dass diese beispielsweise eine Epoxydharzmasse umfasst (molding resin). Zum Aufbringen der Moldmasse können, insbesondere in Verbindung mit einer Epoxydharzmasse, beispielsweise ein Gießverfahren und/oder Pressverfahren verwendet werden, wobei besonders bevorzugt Transfermolding-Verfahren eingesetzt werden. Unter einem Transfermolding-Verfahren ist dabei ein Verfahren zu verstehen, bei welchem die Moldmasse, beispielsweise eine Epoxydharzmasse und/oder ein Vorprodukt derselben, vorgeheizt wird und in eine Kammer geladen wird. Von dort wird das fließfähige Material aus der Kammer mittels eines Kolbens durch Kanäle in Formnester eines Werkzeugs geleitet. Die Wände dieser Formnester werden üblicherweise über den Schmelzpunkt des Umhüllungsmaterials geheizt. Beim Transfermolding-Verfahren können Duroplaste, wie beispielsweise Epoxydharzmassen eingesetzt werden. Eine Aushärtung kann unmittelbar in der Form erfolgen oder beispielsweise auch später. Die Moldmasse dichtet das in der Ausnehmung befindliche Trägersubstrat zuverlässig ab. Nach der Einfüllung der Moldmasse in die Ausnehmung stützt sich die gehärtete Moldmasse vorteilhaft auch an der Innenwandung der Ausnehmung ab, wodurch Scherkräfte, welche eine Ablösung der Moldmasse zur Folge haben könnten, vorteilhaft reduziert werden und die Moldmasse mit der Leiterplatte fest verbunden ist. Die Moldmasse weist eine hohe Haftfestigkeit auf der ersten Seite der Leiterplatte auf, so dass ein Eindringen von Getriebefluid in Spalte zwischen der Moldmasse und der Leiterplatte zuverlässig verhindert wird. Die Moldmasse dient aber auch vorteilhaft zur zusätzlichen mechanischen Befestigung des Trägersubstrats an der Leiterplatte, wobei das Trägersubstrat durch die Moldmasse in besonders zuverlässiger und kompakter Weise mit der Leiterplatte verbunden ist.

Erfindungsgemäß ist vorgesehen, dass auf der von der ersten Seite der Leiterplatte abgewandten zweiten Seite der Leiterplatte eine zweite äußere Isolierlage mit einer zweiten Ausnehmung versehen ist, welche bis zu einer von der ersten Seite der Leiterplatte abgewandten und mit Bauelementen bestückten Rückseite des Trägersubstrats hindurchgeführt ist, und dass die zweite Ausnehmung auf der zweiten Seite der Leiterplatte mit einer die Rückseite des Trägersubstrats abdeckenden Moldmasse gefüllt ist und die Rückseite des Trägersubstrats somit durch die Moldmasse gegen Getriebefluid geschützt ist. Das Trägersubstrat der elektronischen Getriebesteuerschaltung kann somit vorteilhaft beidseitig mit elektrischen/elektronischen Bauelementen bestückt werden, die in die zweite Ausnehmung der Leiterplatte hineinragen können. Dadurch können auf dem Trägersubstrat auch ohne Vergrößerung der lateralen Abmessungen desselben höhere Bestückungsdichten mit elektrischen/elektronischen Bauelementen erreicht werden.
Vorteilhafte Ausbildungen und Weiterentwicklungen der Erfindung werden durch die in den abhängigen Ansprüchen angegebenen Maßnahmen ermöglicht.

Dadurch, dass die Moldmasse die Ausnehmung vollständig füllt und an der ersten Seite der Leiterplatte eine die Ausnehmung umgebende äußere Randfläche der Leiterplatte abdeckt, wird vorteilhaft ein vergrößerter Dichtbereich geschaffen, in dem die Moldmasse fest an der ersten Seite der Leiterplatte anhaftet. Die Wahrscheinlichkeit des Eindringens von Getriebefluid in Spalte zwischen der Moldmasse und der Leiterplatte wird dadurch vorteilhaft noch weiter reduziert.

Das Trägersubstrat kann vorteilhaft über Bonddrähte mit den Oberflächen der Leiterbahnabschnitte der Leiterbahnen elektrisch kontaktiert werden. In diesem Fall ist das Trägersubstrat beispielsweise am Grund der Ausnehmung zwischen den Enden von Leiterbahnabschnitten von Leiterbahnen der inneren Leiterbahnlage angeordnet und beispielsweise auf die am Grund der Ausnehmung befindliche Isolierlage aufgeklebt. Die Herstellung von Bondverbindung zwischen dem Trägersubstrat und den in der Aussparung zugänglichen Leiterbahnabschnitten kann problemlos durchgeführt werden. Die Moldmasse, mit der die Ausnehmung aufgefüllt wird, umgibt auch die Bonddrähte und schützt dadurch zuverlässig die elektrische Verbindung zwischen Trägersubstrat und Leiterplatte.

Es ist aber auch möglich, das Trägersubstrat an seiner von der ersten Seite der Leiterplatte abgewandten Rückseite mittels Kontaktelementen mit den Oberflächen der Leiterbahnabschnitte der Leiterbahnen elektrisch zu kontaktieren. In diesem Fall weist das Trägersubstrat auf der in die Ausnehmung eingesetzten Rückseite Kontaktelemente beispielsweise in der Form von Lötkontakten oder Leiterkleberverbindungen auf, welche die Leiterbahnabschnitte direkt kontaktieren. Vorteilhaft kann in diesem Ausführungsbeispiel die Größe der Aussparung reduziert werden, da das Trägersubstrat direkt oberhalb der Leiterbahnabschnitte am Grund der Ausnehmung angeordnet wird und kein seitlicher Raum für die Anbringung von Bonddrähten bereitgestellt werden braucht.

### Kurze Beschreibung der Zeichnungen

Ausführungsbeispiele der Erfindung sind in den Zeichnungen dargestellt und werden in der nachfolgenden Beschreibung näher erläutert. Es zeigen
- Figur 1: einen Querschnitt durch ein Steuermodul, welches nur der Erläuterung dient,
- Figur 2: einen Querschnitt durch ein Ausführungsbeispiel der Erfindung mit einer beidseitigen Befüllung der Leiterplatte mit Moldmasse.

### Ausführungsformen der Erfindung

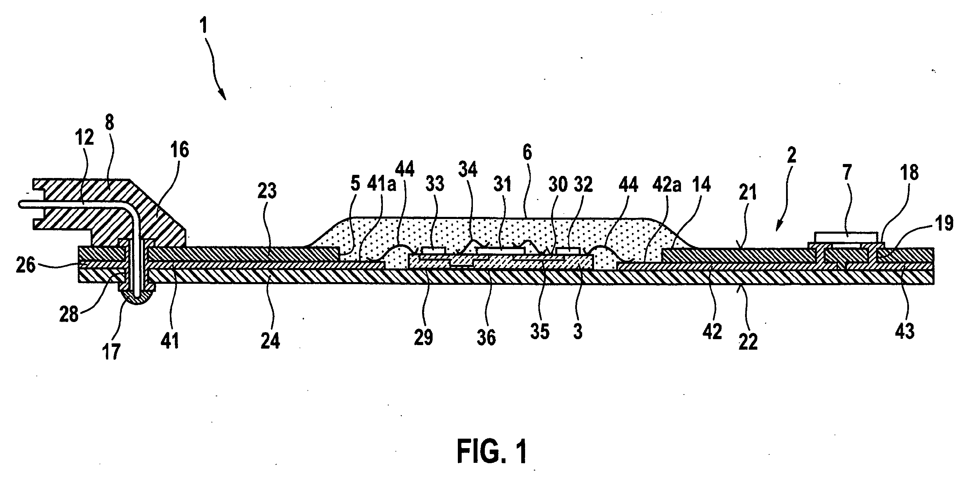

Figur 1 zeigt einen Querschnitt durch ein Getriebesteuermoduls 1, welches beispielsweise im Automatikgetriebe eines Kraftfahrzeuges verbaut werden kann. Grundsätzlich sind gleiche oder stark ähnliche Teile mit den gleichen Bezugszeichen versehen.

Das Getriebesteuermodul ist dazu bestimmt, wenigstens teilweise oder vollständig dem im Getriebe vorhandenen Getriebefluid (ATF) ausgesetzt zu sein, und dient zur Ansteuerung von Stellern und dem Auslesen von Sensoren zur Betätigung eines Automatikgetriebes. Das Getriebesteuermodul kann selbstverständlich an die jeweils erforderlichen Rahmenbedingungen, wie Anzahl und Art der anzusteuernden Aktuatoren, Sensoren und Steckanschlüsse angepasst werden. Das Getriebesteuermodul kann einen in den Figuren nicht dargestellten Grundkörper aufweisen, der beispielsweise durch ein komplexes Kunststoffteil oder eine metallische Trägerplatte gebildet werden kann, worauf eine Leiterplatte aufgebracht ist. Der Grundkörper kann entfallen, wenn die Leiterplatte dessen mechanische Befestigungsfunktion übernimmt und alle Komponenten des Steuermoduls direkt an der Leiterplatte befestigt sind. Bei der Leiterplatte 2 handelt es sich beispielsweise um eine konventionelle Leiterplatte aus glasfaserverstärktem Epoxydharz oder einem ähnlichen Material. In Frage kommen beispielsweise Leiterplatten aus FR4 oder höherwertige Leiterplattensubstrate. Leiterbahnen der Leiterplatte 2 bestehen vorzugsweise aus Kupfer, wie in der Leiterplattentechnik üblich. Es können aber auch andere elektrisch leitfähige oder metallische Materialien eingesetzt werden. Insbesondere können einlagige oder mehrlagige Leiterplatten, sogenannte Mehrlagenleiterplatten verwandt werden.

Die Leiterplatte 2 weist eine erste Seite 21 und eine von der ersten Seite 21 abgewandte zweite Seite 22 auf. Weiterhin weist die Leiterplatte 2 wenigstens eine innere Leiterbahnlage 26 auf, in der einzelne Leiterbahnen geführt sind. In Figur 1 sind beispielhaft drei Leiterbahnen 41, 42, 43 der inneren Leiterbahnlage 26 zu erkennen. Die innere Leiterbahnlage 26 ist zwischen einer ersten Isolierlage 23 und einer zweiten Isolierlage 24 in der Leiterplatte eingebettet, wobei die erste Isolierlage 23 und die zweite Isolierlage 24 zugleich Außenbereiche der Leiterplatte 2 bilden. Die Leiterplatte 2 dient zur Kontaktierung von Aktuatoren, beispielsweise elektrohydraulischen Drucksteuerventilen, Sensoren und Steckern oder anderen Komponenten mit einer elektronischen Getriebesteuerschaltung.

In Fig. 1 ist als Beispiel für eine mit der Leiterplatte verbundene Komponente ein Steckerteil 8 dargestellt, das auf die Leiterplatte 2 bestückt ist. Das Steckerteil 8 weist Kontaktelemente 12 auf, die in einem Steckergehäuse 16 aus Kunststoff angeordnet sind. Das Kunststoffgehäuse 16 ist beispielsweise mit dem Kontaktelement 12 in eine metallisierte Durchkontaktierung 28 der Leiterplatte 2 einbebracht und beispielsweise mittels Lot 17 mit der Durchkontaktierung 28 elektrisch verbunden. Über die Durchkontaktierung 28 wird eine elektrische Verbindung zu einer Leiterbahn 41 der inneren Leiterbahnlage 26 dargestellt. Das Steckerteil 8 ist also mechanisch und elektrisch mit der Leiterplatte 2 verbunden. Techniken zur Kontaktierung von Bauelementen auf Leiterplatten sind hinlänglich bekannt, so dass an dieser Stelle nicht näher darauf eingegangen werden braucht. Auf den Außenseiten der Leiterplatte 2 können weitere Bauelemente angeordnet sein, beispielsweise das in Fig. 1 dargestellte Bauelement 7, welches auf Anschlussflächen 18 auf der ersten Seite 21 der Leiterplatte aufgebracht ist und mit den Anschlussflächen 18 elektrisch verbunden ist. Die Anschlussflächen 18 sind über elektrische Zwischenverbindungen (VIAS) der Leiterplatte 2 mit Leiterbahnen 42 und 43 der inneren Leiterbahnlage 26 kontaktiert. Falls erforderlich kann das Bauelement 7 beispielsweise durch eine Schutzabdeckung oder eine Schutzbeschichtung gegen Getriebefluid geschützt werden. Das Bauelement 7 kann beispielsweise ein Sensor, zum Beispiel ein Temperatursensor oder Drucksensor oder ein Drehzahlsensor sein. Nicht dargestellt in Fig. 1 sind weitere Anschlüsse auf der Leiterplatte 2 für Aktuatoren, wie beispielsweise elektrohydraulische Druckregelventile zur Steuerung von Getriebeschaltvorgängen oder für Stellmotoren von Ölpumpen und anderen elektrischen Komponenten.

Wie in Fig. 1 zu erkennen ist, ist die erste äußere Isolierlage 23 auf der ersten Seite 21 der Leiterplatte 2 mit einer beispielsweise rechteckförmigen Ausnehmung 5 versehen. Die Ausnehmung 5 ist zumindest so tief in die Leiterplatte 2 einbebracht, dass an ihrem Grund Leiterbahnabschnitte 41a, 42a der Leiterbahnen 42, 43 der inneren Leiterbahnlage 26 freigelegt sind. Die Einbringung der Ausnehmung 5 in die Leiterplatte 2 kann vorzugsweise durch einen Fräsvorgang geschehen, bei dem von der ersten Seite 21 der Leiterplatte aus bis auf die innere Leiterbahnlage 26 gefräst wird, so dass zumindest die Oberflächen der Leiterabschnitte 41a, 42a freigelegt sind.

Das Getriebesteuermodul umfasst weiterhin ein Trägersubstrat 3, das mit eine Getriebesteuerschaltung bildenden elektrischen/elektronischen Bauelementen 31, 32, 33 bestückt ist. Das Trägersubstrat 3 kann ein keramischen Hybridsubstrat, insbesondere ein LTCC-Substrat, oder beispielsweise eine Mikroleiterplatte oder ein ähnliches kleines Trägersubstrat sein. Das Trägersubstrat weist eine als Bestückungsseite zur Aufbringung der Bauelemente 32, 32, 33 vorgesehene Oberseite 30 und eine davon abgewandte Rückseite 29 auf. Wie in Fig. 1 dargestellt ist, kann das vorzugsweise rechteckförmige und plattenartige Trägersubstrat 3 beispielsweise Bonddrahtverbindungen 34 oder nicht dargstellte Leiterbahnverbindungen auf der Oberseite 30 und/oder innere Leiterbahnen 35 zur Verdrahtung der Bauelemente 31, 32, 33 untereinander aufweisen.

Die Abmessungen der Aussparung 5 sind so bemessen, dass das Trägersubstrat 3 mit der Rückseite 29 in die Aussparung 5 eingesetzt werden kann. Dabei kann wird in Fig. 1 das Trägersubstrat 3 auf der Rückseite 29 beispielsweise über einen Kleber 36 auf die der Aussparung 5 zugewandte Seite der unteren äußeren Isolierlage 24 aufgeklebt. Das Trägersubstrat kann aber auch in anderer Weise in der Aussparung mechanisch befestigt werden oder es kann vorgesehen sein, die mechanische Befestigung durch die anschließend in die Aussparung eingefüllte Moldmasse 6 zu gewährleisten. In Fig. 1 wird das Trägersubstrat 3 nicht auf die Leiterbahnabschnitte 41a, 42a aufgesetzt, sondern ist von den freien Enden der Leiterbahnabschnitte 41a, 42a der inneren Leiterbahnen 41, 42 beabstandet. Zur elektrischen Verbindung des Trägersubstrats 3 mit den Leiterbahnabschnitten 41a, 42a sind Bonddrähte 44 vorgesehen. In der bekannten Bondtechnik wird das in der Aussparung 5 angeordnete Trägersubstrat 3 über Bonddrähte 44, von denen in Fig. 1 nur zwei zu erkennen sind, mit den Oberflächen der Leiterbahnabschnitte 41 a, 42a elektrisch kontaktiert. Dabei wird auf die parallel zur Erstreckungsrichtung der Leiterbahnen verlaufenden Oberflächen der Leiterbahnabschnitte gebondet. Derartige Bondverbindungen sind auf einfache Weise zuverlässig herstellbar.

Bei der Herstellung des Getriebesteuermoduls wird nach der Einführung des Trägersubstrats 3 und der Herstellung der Bondverbindungen die Moldmasse 6 in die Ausnehmung 5 eingefüllt. Die Moldmasse 6 deckt das Trägersubstrat 3 und die Leiterbahnabschnitte 41a, 42a vollständig ab. Wie in Fig. 1 zu erkennen ist, füllt die Moldmasse 6 die Ausnehmung 5 vollständig auf und steht von der ersten Seite 21 der Leiterplatte kuppenartig hervor, wobei vorzugsweise an der ersten Seite 21 der Leiterplatte 2 auch eine die Ausnehmung 5 umgebende äußere Randfläche 14 der Leiterplatte abgedeckt wird. Als Moldmasse wird, wie bereits beschrieben, vorzugsweise ein in die Ausnehmung eingefülltes und ausgehärtetes Duroplast, vorzugsweise ein Epoxydharz (molding resin) verwandt, das eine gegenüber Getriebefluid dichte und gegen mechanische Einwirkungen schützende, feste Abdeckung bildet. Das Aufbringen der Moldmasse kann bevorzugt durch ein Transfermolding-Verfahren erfolgen, bei dem die Moldmasse, beispielsweise die Epoxidharzmasse, vorgeheizt wird und in eine Kammer geladen wird. Von dort wird das fließfähige Material aus der Kammer mittels eines Kolbens durch Kanäle in Formnester eines Werkzeugs geleitet. Die Wände dieser Formnester werden üblicherweise über den Schmelzpunkt der Moldmasse geheizt. Nach der Aushärtung dichtet die Moldmasse 6 das in der Ausnehmung 5 befindliche Trägersubstrat 3 zuverlässig ab.

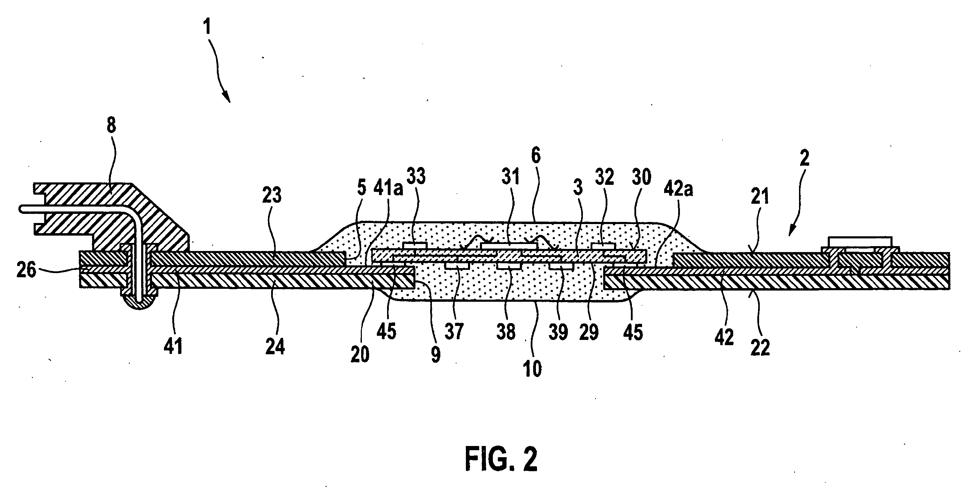

Ein erstes Ausführungsbeispiel der Erfindung ist in Figur 2 dargestellt. Wie in Figur 2 zu erkennen ist, ist das Trägersubstrat 3 nicht nur auf der Oberseite 30 mit Bauelementen 31, 32, 33, sondern auch auf der davon abgewandten Rückseite 29 mit weiteren Bauelementen 37, 38, 39 versehen. Damit die auf der Rückseite 29 angeordneten Bauelemente 37, 38, 39 nicht den Grund der Aussparung 5 berühren, ist nun die Leiterplatte 2 auf der von der ersten Seite 21 abgewandten zweiten Seite 22 mit einer weiteren Ausnehmung 9 versehen, die in die zweite äußere Isolierlage 24 eingebracht ist und bis zu ersten Ausnehmung 5 hindurchgeführt ist. Folglich bilden die erste Ausnehmung 5 und die zweite Ausnehmung 9 einen Durchgang aus. Die Abmessungen der zweiten Ausnehmung 9 sind jedoch etwas kleiner ausgerührt als die Abmessungen der ersten Ausnehmung 5, so dass die zweite äußere Isolierlage 24 in dem Durchgang einen nach Innen vorspringenden Rahmen 20 ausbildet. Das Trägersubstrat 3 ist mit der Rückseite 29 auf diesen Rahmen 20 aufgesetzt, so dass die Bauelemente 37 bis 39 auf der Rückseite des Trägersubstrats 3 in die zweite Ausnehmung 9 eingreifen können. Obwohl in diesem Ausführungsbeispiel eine Kontaktierung des Trägersubstrats 3 mit den Leiterbahnen 41, 42 über Bonddrähte erfolgen könnte, ist vorzugsweise abweichend von Figur 1 vorgesehen, das Trägersubstrat 3 auf der Rückseite 29 über Kontaktelemente 45 mit den Oberflächen der Leiterbahnabschnitte 41a, 42a zu kontaktieren. Diese Kontaktelemente 45 können beispielsweise durch Leitkleberverbindungen oder Lötkontakte gebildet werden, die auf der Rückseite 29 des Trägersubstrat mit dort vorhandenen Kontaktflächen elektrisch leitend verbunden sind.

Weiterhin können auch mehr als zwei innere Leiterbahnlagen vorgesehen sein. Allgemein kann die Erfindung bei Mehrlagenleiterplatten mit zwei, drei, vier oder mehr inneren Leiterbahnlagen zur Anwendung gelangen.

Die dargestellten Ausführungsbeispiele dienen nur zur Erläuterung der Erfindung und stellen keine Einschränkung der Erfindung auf die jeweils konkret dargestellten Ausführungsformen dar.

## Patentansprüche

1. Steuermodul , umfassend eine von außen zumindest teilweise zugängliche Leiterplatte (2) mit auf wenigstens einer Lage der Leiterplatte (2) geführten Leiterbahnen (41, 42, 43) zur elektrischen Verbindung eines Trägersubstrats (3) einer elektronischen Steuerschaltung mit außerhalb des Trägersubstrats (3) an der Leiterplatte (2) angeordneten elektrischen/elektronischen Komponenten (7, 8), wobei die Leiterplatte wenigstens eine innere Leiterbahnlage (26) aufweist, die als Zwischenlage zwischen zwei Iso-lierlagen (23, 24) der Leiterplatte (2) angeordnet ist, wobei wenigstens auf einer ersten Seite (21) der Leiterplatte (2) eine erste äußere Isolierlage (23) mit einer Ausnehmung (5) versehen ist, an deren Grund wenigstens Oberflächen von Leiterbahnabschnitten (41a, 42a) von Leiterbahnen (41, 42) der wenigstens einen inneren Leiterbahnlage (26) angeordnet sind, dass das Trägersubstrat (3) von der ersten Seite der Leiterplatte (2) in die Ausnehmung (5) eingesetzt und mit den Oberflächen der Leiterbahnabschnitte (41a, 42a) der inneren Leiterbahnlage (26) elektrisch kontaktiert ist und dass die Ausnehmung (5) mit einer zumindest das Trägersubstrat (3) und die Leiterbahnabschnitte (41a, 42a) abdeckenden Moldmasse (6) derart gefüllt ist, dass das Trägersubstrat (3) und die Leiterbahnabschnitte (41a, 42a) durch die Moldmasse (6) geschützt sind, **dadurch gekennzeichnet, dass** das Steuermodul ein Getriebesteuermodul (1) ist, dass die Leiterplatte (2) einem Getriebefluid aussetzbar ist, dass die Steuerschaltung eine Getriebesteuerschaltung ist, dass das Trägersubstrat (3) und die Leiterbahnabschnitte (41a, 42a) durch die Moldmasse (6) gegen Getriebefluid geschützt sind und dass auf der von der ersten Seite (21) abgewandten zweiten Seite (22) der Leiterplatte (2) eine zweite äußere Isolierlage (24) mit einer zweiten Ausnehmung (9) versehen ist, welche bis zu einer von der ersten Seite (21) der Leiterplatte (2) abgewandten und mit Bauelementen (37, 38, 39) bestückten Rückseite (29) des Trägersubstrats (3) hindurchgeführt ist, und dass die zweite Ausnehmung (9) auf der zweiten Seite (22) der Leiterplatte (2) mit einer die Rückseite (29) des Trägersubstrats (3) abdeckenden Moldmasse (9) derart gefüllt ist, dass die Rückseite (29) des Trägersubstrats (3) durch die Moldmasse (9) gegen Getriebefluid geschützt ist.

2. Getriebesteuermodul nach Anspruch 1, **dadurch gekennzeichnet, dass** die Moldmasse (6) die Ausnehmung (5) vollständig füllt und an der ersten Seite (21) der Leiterplatte (2) eine die Ausnehmung (5) umgebende äußere Randfläche (14) der Leiterplatte (2) abdeckt.

3. Getriebesteuermodul nach Anspruch 1, **dadurch gekennzeichnet, dass** das Trägersubstrat (3) über Bonddrähte (44) mit den Oberflächen der Leiterbahnabschnitte (41a, 42a) der Leiterbahnen (41, 42) elektrisch kontaktiert ist.

4. Getriebesteuermodul nach Anspruch 1, **dadurch gekennzeichnet, dass** das Trägersubstrat (3) an seiner von der ersten Seite (21) der Leiterplatte (2) abgewandten Rückseite (29) mittels Kontaktelementen (45) mit den Oberflächen der Leiterbahnabschnitte (41a, 42a) der Leiterbahnen (41, 42) elektrisch kontaktiert ist.

5. Getriebesteuermodul nach Anspruch 4, **dadurch gekennzeichnet, dass** die Kontaktelemente (45) durch Leitkleber oder Lötkontakte gebildet sind.

## Claims

1. Control module, comprising a printed circuit board (2), which is at least partially accessible from the outside and has conductor tracks (41, 42, 43) that are routed on at least one layer of the printed circuit board (2) and are intended for the electrical connection of a carrier substrate (3) of an electronic control circuit to electrical/electronic components (7, 8) arranged outside the carrier substrate (3) on the printed circuit board (2), the printed circuit board having at least one inner conductor track layer (26), which is arranged as an intermediate layer between two insulating layers (23, 24) of the printed circuit board (2), wherein, at least on a first side (21) of the printed circuit board (2), a first outer insulating layer (23) is provided with a recess (5), on the base of which at least surfaces of conductor track portions (41a, 42a) of conductor tracks (41, 42) of the at least one inner conductor track layer (26) are arranged, in that the carrier substrate (3) is inserted into the recess (5) from the first side of the printed circuit board (2) and brought into electrical contact with the surfaces of the conductor track portions (41a, 42a) of the inner conductor track layer (26), and in that the recess (5) is filled with a molding compound (6), covering at least the carrier substrate (3) and the conductor track portions (41a, 42a), in such a way that the carrier substrate (3) and the conductor track portions (41a, 42a) are protected by the molding compound (6) **characterized in that** the control module is a transmission control module (1), **in that** the printed circuit board (2) can be exposed to a transmission fluid, **in that** the control circuit is a transmission control circuit, **in that** the carrier substrate (3) and the conductor track portions (41a, 42a) are protected from transmission fluid by the molding compound (6) and **in that**, on the second side (22) of the printed circuit board (2), facing away from the first side (21), a second outer insulating layer (24) is provided with a second recess (9), which is taken through to a rear side (29) of the carrier substrate (3) that is facing away from the first side (21) of the printed circuit board (2) and is loaded with components (37, 38, 39), and **in that** the second recess (9) on the second side (22) of the printed circuit board (2) is filled with a molding compound (9) covering the rear side (29) of the carrier substrate (3) in such a way that the rear side (29) of the carrier substrate (3) is protected from transmission fluid by the molding compound (9).

2. Transmission control module according to Claim 1, **characterized in that** the molding compound (6) fills the recess (5) completely and, on the first side (21) of the printed circuit board (2), covers an outer peripheral surface (14) of the printed circuit board (2) surrounding the recess (5).

3. Transmission control module according to Claim 1, **characterized in that** the carrier substrate (3) is brought into electrical contact with the surfaces of the conductor track portions (41a, 42a) of the conductor tracks (41, 42) by way of bonding wires (44).

4. Transmission control module according to Claim 1, **characterized in that** the carrier substrate (3) is brought into electrical contact with the surfaces of the conductor track portions (41a, 42a) of the conductor tracks (41, 42) on its rear side (29), facing away from the first side (21) of the printed circuit board (2), by means of contact elements (45).

5. Transmission control module according to Claim 4, **characterized in that** the contact elements (45) are formed by conductive adhesive or solder contacts.

## Revendications

1. Module de commande, comprenant un circuit imprimé (2) au moins partiellement accessible depuis l'extérieur et comprenant des pistes conductrices (41, 42, 43) guidées sur au moins une couche du circuit imprimé (2) en vue de réaliser la liaison électrique d'un substrat porteur (3) d'un circuit de commande électronique avec des composants électriques/électroniques (7, 8) disposés à l'extérieur du substrat porteur (3) sur le circuit imprimé (2), le circuit imprimé possède au moins une couche de piste conductrice interne (26) qui est disposée en tant que couche intermédiaire entre deux couches isolantes (23, 24) du circuit imprimé (2), une première couche isolante externe (23) au moins sur un premier côté (21) du circuit imprimé (2) étant munie d'une cavité (5) à la base de laquelle sont disposées au moins les surfaces de portions de pistes conductrices (41a, 42a) des pistes conductrices (41, 42) de l'au moins une couche de piste conductrice interne (26), en ce que le substrat porteur (3) est inséré dans la cavité (5) depuis le premier côté du circuit imprimé (2) et est amené en contact électrique avec les surfaces des portions de pistes conductrices (41a, 42a) de la couche de piste conductrice interne (26) et en ce que la cavité (5) est remplie avec une masse de moulage (6) qui recouvre au moins le substrat porteur (3) et les portions de pistes conductrices (41a, 42a) de telle sorte que le substrat porteur (3) et les portions de pistes conductrices (41a, 42a) sont protégés par la masse de moulage (6), caractérisé en ce le module de commande est un module de commande d'engrenage (1), en ce que le circuit imprimé (2) peut être exposé à un fluide d'engrenage, en ce que le circuit de commande est un circuit de commande d'engrenage, en ce que le substrat porteur (3) et les portions de pistes conductrices (41a, 42a) sont protégés du fluide d'engrenage par la masse de moulage (6) et en ce qu'une deuxième couche isolante (24) sur le deuxième côté (22) du circuit imprimé (2) qui est à l'opposé du premier côté (21) est munie d'une deuxième cavité (9) qui traverse jusqu'à un côté arrière (29) du substrat porteur (3) à l'opposé du premier côté (21) du circuit imprimé (2) et équipé de composants (37, 38, 39), et en ce que la deuxième cavité (9) sur le deuxième côté (22) du circuit imprimé (2) est remplie d'une masse de moulage (9) qui recouvre le côté arrière (29) du substrat porteur (3) de telle sorte que le côté arrière (29) du substrat porteur (3) est protégé du fluide d'engrenage par la masse de moulage (9).

2. Module de commande d'engrenage selon la revendication 1, **caractérisé en ce que** la masse de moulage (6) remplit entièrement la cavité (5) et, sur le premier côté (21) du circuit imprimé (2), recouvre une surface de bordure extérieure (14) du circuit imprimé (2) qui entoure la cavité (5).

3. Module de commande d'engrenage selon la revendication 1, **caractérisé en ce que** le substrat porteur (3) est en contact électrique par le biais de fils de connexion (44) avec les surfaces des portions de pistes conductrices (41a, 42a) des postes conductrices (41, 42).

4. Module de commande, d'engrenage selon la revendication 1, **caractérisé en ce que** le substrat porteur (3) est en contact électrique avec les surfaces des portions de pistes conductrices (41a, 42a) des postes conductrices (41, 42) au moyen d'éléments de contact (45) sur son côté arrière (29) à l'opposé du premier côté (21) du circuit imprimé (2).

5. Module de commande d'engrenage selon la revendication 4, **caractérisé en ce que** les éléments de contact (45) sont formés par de la colle conductrice ou des contacts brasés.
